# NEUE EUROPÄISCHE PATENTSCHRIFT

(11) **EP 0 671 367 B2**
(45) Veröffentlichungstag und Bekanntmachung des Hinweises auf die Entscheidung über den Einspruch: **02.05.2003**
(45) Hinweis auf die Patenterteilung: 12.11.1997
(21) Anmeldenummer: 95103239.0
(22) Anmeldetag: 07.03.1995
(51) Int. Cl.: C03C 17/00, C23C 14/54, C23C 14/56, C23C 16/52, C23C 16/54

(54) **Verfahren und Vorrichtung zum kontinuierlichen oder quasikontinuierlichen Beschichten von Brillengläsern**
Process and apparatus for continuous or semi-continuous coating of spectacle lenses
Procédé et dispositif de revêtement continu ou quasi-continu de verres de lunettes

(30) Priorität: 09.03.1994 DE 4407909
(43) Veröffentlichungstag der Anmeldung: 13.09.1995
(73) Patentinhaber: Balzers und Leybold Deutschland Holding Aktiengesellschaft, 63450 Hanau (DE)
(72) Erfinder: Beisswenger, Siegfried, Dr. Dipl.-Phys., D-63755 Alzenau (DE); Fliedner, Michael, Dipl.-Phys., D-63486 Bruchköbel (DE)
(74) Vertreter: Zapfe, Hans, Dipl.-Ing.

(56) Entgegenhaltungen:
- EP-A- 0 444 618
- WO-A-92/13114
- DE-C- 3 344 850
- JP-A- 3 270 728
- PATENT ABSTRACTS OF JAPAN vol. 16 no. 81 (C-915) ,27.Februar 1992 & JP-A-03 270728 (HITACHI LTD) 2.Dezember 1991,
- SIEMENS: Flexible Manufacture of Spectacle Lenses at Zeiss in Aalen, Reprint from "engineering & automation", vol. XVI, No. 1/94.

## Beschreibung

Die Erfindung betrifft ein Verfahren zum Beschichten von Brillengläsern in einer Vakuumanlage.

Brillengläser werden mit Ein- oder Mehrfachschichten versehen, um sie zu entspiegeln und/oder den Brillengläsern gewisse Reflexfarben zu verleihen, die gegebenenfalls auch modischen Schwankungen unterliegen. Brillengläser aus Kunststoff werden auch mit kratzfesten Schutzschichten versehen, um ihre Lebensdauer zu verlängern.

Es ist durch die DE 41 15 175 A1 bekannt. Brillengläser chargenweise zu beschichten, indem man sie in einer Vielzahl an einem kalottenförmigen Substrathalter befestigt und sie mittels eines Aufdampfverfahrens beschichtet. Einerseits wird hierbei eine größere Menge von Brillengläsern fertiggestellt, die mit den gleichen Schichtmaterialien versehen sind, andererseits ist es aber aufgrund der ungleichförmigen Dampfausbreitung von der Beschichtungsquelle praktisch unmöglich, sämtliche Brillengläser der gleichen Charge mit Schichten der gleichen Schichtdicke zu versehen. Abgesehen von dieser Problematik lassen sich derartige Chargen-Anlagen nicht in den üblichen Fertigungsablauf in einer modernen Brillenglasfertigung integrieren, durch die die Brillengläser einzeln oder paarweise fertiggestellt und auch weiterverarbeitet werden. Brillengläser werden im allgemeinen paarweise "nach Rezept" mit den gleichen Eigenschaften hergestellt, und auch diesbezüglich sind die bekannten Chargen-Anlagen unflexibel, um nacheinander Brillengläser mit unterschiedlichen Krümmungsradien und unterschiedlichen Beschichtungsmaterialien herstellen zu können.

Ein weiterer Nachteil der bekannten Chargen-Anlagen besteht darin, daß die kalottenförmigen Substrathalter von Hand mit den Brillengläsern bestückt werden müssen, wobei die Gefahr einer Beschädigung besteht. Eine Automatisierung dieses Vorganges ist praktisch nicht möglich.

Der Erfindung liegt daher die Aufgabe zugrunde, ein Beschichtungsverfahren für Brillengläser anzugeben, das sich in den herkömmlichen Herstell- und Weiterverarbeitungsprozeß der beschichteten Brillengläser integrieren läßt und das es ermöglicht. Brillengläser einzeln oder paarweise mit genau vorgegebenen Schichten oder Schichtsystemen zu versehen.

Die Lösung der gestellten Aufgabe erfolgt bei dem eingangs beschriebenen Verfahren erfindungsgemäß durch die Merkmale des Patent-anspruchs 1.

Mittels der Erfindung werden die Brillengläser gewissermaßen von einem Fließband aufgenommen, in der Beschichtungsanlage beschichtet und nachfolgend wieder auf dem Fließband oder auf einem weiterem Fließband abgelegt. In der Beschichtungsanlage wird jeweils in einem statischen Beschichtungsprozeß eine Einfach- oder Mehrfachschicht aufgebracht. Es können sich ein oder mehrere Brillengläser gleichzeitig in der Beschichtungsanlage befinden. Die Beschichtungsanlage kann eine oder mehrere Beschichtungsstationen aufweisen. Das erfindungsgemäße Verfahren läßt sich taktweise betreiben. Bei einer Taktzeit von 60 Sekunden können beispielsweise 60 Brillengläser oder 60 Paare von Brillengläsern pro Stunde beschichtet werden. Das betreffende Verfahren läßt sich auf einfache Weise in den Herstell- und Weiterverarbeitungsprozeß von Brillengläsern integrieren.

Beim erfindungsgemäßen Verfahren entfällt weiterhin die Notwendigkeit eines Beladens der Beschichtungsanlage von Hand.

Dadurch, daß man den Brillengläsern einzeln oder paarweise eine Codierung zuordnet, die Codierung mittels einer Code-Leseeinrichtung abfragt und die Beschichtungsparameter der jeweiligen Beschichtungsstation und den Antrieb des Substratträgers mittels der Code-Leseeinrichtung steuert, wird der Beschichtungsvorgang automatisiert. Insbesondere können die Schichteigenschaften von Substrat zu Substrat gezielt geändert werden,so daß es möglich ist, die Reflexfarben einer Antireflex-Schicht nach entsprechenden Vorgaben zu steuern. Dadurch wird eine außerordentlich große Flexibilität der gesamten Beschichtungstechnik erreicht.

Die Codierung kann dabei Informationen enthalten über den Durchmesser, den Werkstoff und die Krümmung bzw. Dioptrienzahl der Brillengläser sowie über die Refiexfarben und die Anzahl der Einzelschichten des Schichtsystems.

Es ist dabei weiterhin von Vorteil, wenn man die Brillengläser einzeln oder paarweise auf einer Transportpalette ablegt und die Transportpalette mit der Codierung versieht. Derartige Transportpaletten können unterschiedlichen Abmessungen der Brillengläser angepaßt werden, so daß die Beschichtungsanlage selbst nicht auf unterschiedliche Brillenglasdurchmesser umgerüstet werden muß.

Die Erfindung betrifft auch eine Vakuumanlage zum Beschichten von Brillengläsern mit einer Vakuumkammer mit mindestens einer steuerbaren Beschichtungsstation.

Zur Lösung der gleichen Aufgabe ist eine solche Vakuumanlage gekennzeichnet durch die Merkmale des Patentanspruchs 6,

Dabei ist es besonders vorteilhaft, wenn die Steuereinrichtung für den Substratträger in der Weise ausgelegt ist, daß der Substratträger zumindest zeitweise mit entgegengesetztem Drehsinn antreibbar ist, derart, daß mindestens eine der Beschichtungsstationen mehrfach durchlaufen wird.

Besonders gute Schichtqualitäten werden dann erzielt, wenn mindestens eine der Beschichtungsstationen als Katodenzerstäubungsvorrichtung ausgebildet ist.

Die Beschichtungsgeschwindigkeit läßt sich dann in besonders vorteilhafter Weise steigern, beispielsweise für die Herstellung sogenannter Schutzschichten, wenn mindestens eine der Beschichtungsstationen als PCVD-Beschichtungsquelle ausgebildet ist.

Weitere vorteilhafte Ausgestaltungen des Erfindungsgegenstandes ergeben sich aus den übrigen Unteransprüchen.

Die Brillengläser kommen dabei kontinuierlich oder quasi-kontinuierlich mittels der Transporteinrichtung an einer Seite der Beschichtungsanlage an. Von der Aufnahmeeinrichtung und von der Ablegeeinrichtung, wird das zuletzt beschichtete Brillenglas oder ein Paar von Brillengläsern aus dem Schleusensystem ausgeladen und auf der Transporteinrichtung abgelegt, die in besonders einfacher Weise als Transportband ausgeführt sein kann.

Gleichzeitig wird ein unbeschichtetes Brillenglas in das Schleusensystem eingelegt. Der als Drehtisch ausgebildete Substratträger dreht sich durch die einzelnen Beschichtungsstationen hindurch, die auf einer dem Transportweg der Brillengläser entsprechenden Kreisbahn angeordnet sind. Durch ein taktweises Weiterdrehen des Substratträgers werden die Substrate von Beschichtungsstation zu Beschichtungsstation und schließlich zum Schleusensystem transportiert.

Das einfachste Schichtsystem, das zur Zeit bei der Entspiegelung von Brillengläsern aus Mineralglas angewendet wird, besteht aus einer Einzelschicht. Da derzeit etwa 50 % der entspiegelten Brillengläser aus Mineralglas nur eine solche Einzelschicht aufweisen, genügt es hierbei, die Beschichtungsanlage mit nur einer einzigen Beschichtungsstation auszustatten.

Ein etwas komplizierteres Schichtsystem besteht aus einer Doppelschicht, d.h. bei einem aus Mineralglas bestehenden Brillenglas wird zunächst eine hochbrechende Schicht und schließlich eine niedrigbrechende Schicht niedergeschlagen. Für ein solches Schichtsystem wird eine Beschichtungsanlage mit zwei Beschichtungsstationen benötigt. Sofern ein solches Schichtsystem auf Brillengläsern aus Kunststoff niedergeschlagen wird, ist eine zusätzliche Haftschicht erforderlich, d.h. für die Beschichtung von Brillengläsern aus Kunststoffen sind mindestens drei Beschichtungsstationen erforderlich, von denen die erste die Haftschicht erzeugt, die zweite die hochbrechende Schicht und die dritte die niedrigbrechende Schicht.

Mit dem Erfindungsgegenstand ist es darüber hinaus möglich, mittels einer Beschichtungsanlage, die über zwei oder drei Beschichtungsstationen verfügt, auf Brillengläsern aus Kunststoff oder Mineralglas auch kompliziertere Entspiegelungsschichten abzuscheiden. Diese komplizierteren Mehrfachschicht-Systeme bestehen üblicherweise abwechselnd aus hoch- und niedrigbrechenden Schichten. In einem solchen Falle ist es durch abwechselndes Vorwärts- und Rückwärtsdrehen des Substratträgers von einer zu einer anderen Beschichtungsstation möglich, nahezu beliebige mehrschichtige Entspiegelungsschichten herzustellen.

Die den Brillengläsern zugeordnete Codierung, die beispielsweise aus einem Streifen-Code bestehen kann, definiert die vorgeschriebenen Eigenschaften des fertigen Brillenglases. Dieser Streifen-Code wird von einer auf dem Transportweg der Brillengläser vor der ersten Beschichtungsstation angeordneten Code-Leseeinrichtung abgefragt, und die Ausgangssignale der Code-Leseeinrichtung werden zur Steuerung der Beschichtungs-Parameter sowie zur Steuerung der Taktzeit und der Drehrichtung des Substratträgers verwendet.

Als niedrigbrechendes Material kann beispielsweise SiO₂, als hochbrechendes Material kann beispielsweise TiO₂ verwendet werden.

Die größte Schichtdicke bzw. die geringste Beschichtungsrate bzw. beide Einflußgrößen bestimmen die Taktzeit. Im Falle der Katodenzerstäubung führt das genannte TiO₂ zu einer relativ niedrigen Sputterrate. In einem solchen Falle ist es besonders vorteilhaft, die Beschichtungsstation für TiO₂ doppelt oder dreifach auszuführen, um den Durchsatz der gesamten Anlage an eine höhere Beschichtungsgeschwindigkeit anderer Beschichtungsstationen anpassen zu können. Analoge Überlegungen gelten für die Herstellung einer dickeren Schutzschicht.

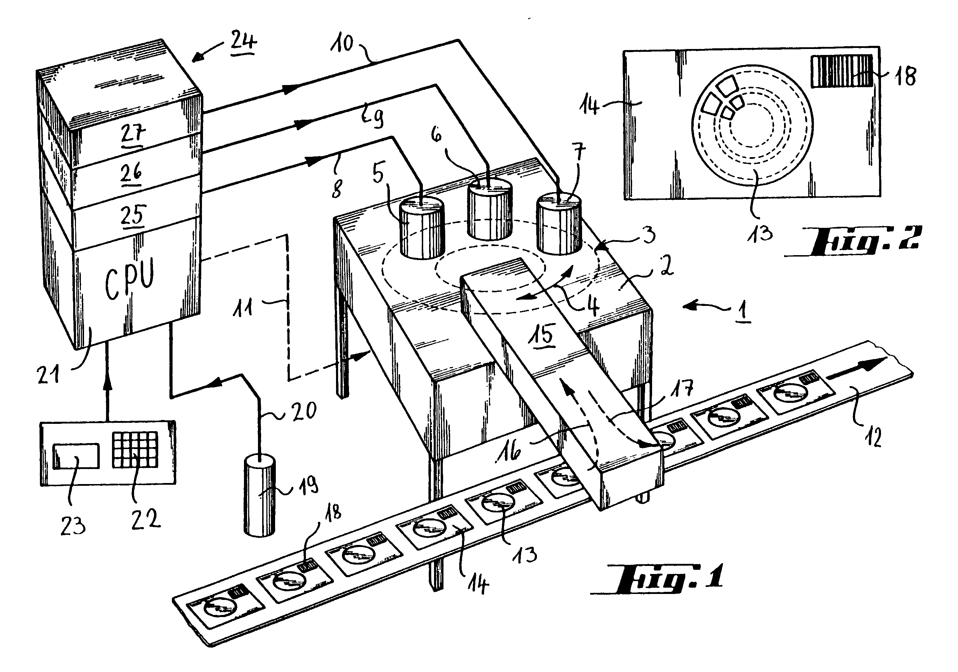

Ein Ausführungsbeispiel des Erfindungsgegenstandes wird nachstehend anhand der Figuren 1 und 2 näher erläutert.

Es zeigen:
- Figur 1: eine Prinzipdarstellung einer VakuumBeschichtungsanlage mit drei Beschichtungsstationen und einer Steuereinrichtung in perspektivischer Darstellung und
- Figur 2: eine Draufsicht auf eine Transportpalette mit einem Brillenglas und einem Streifen-Code.

In Figur 1 ist eine Vakuumanlage 1 dargestellt, die aus einer quaderförmigen Vakuumkammer 2 mit einem drehbaren Substratträger 3 besteht, der durch einen Doppelkreis angedeutet ist. Dieser Substratträger 3 kann durch einen nicht gezeigten Antrieb gemäß dem Pfeil 4 in beiden Drehrichtungen bewegt werden.

in der Decke der Vakuumkammer 2 befinden sich über dem durch den Substratträger 3 definierten Transportweg drei Beschichtungsstationen 5, 6 und 7, die in dem dargestellten Ausführungsbeispiel als Katodenzerstäubungsvorrichtungen ausgeführt sind. Katodenzerstäubungssysteme, die auch im vorliegenden Fall zweckmäßigerweise als Magnetron-Katoden ausgeführt sind, sind seit langem bekannt; sie erhalten ihre elektrische Leistung über drei Leitungen 8, 9 und 10. Eine weitere, gestrichelt dargestellte Leitung 11 führt zu dem nicht dargestellten Antrieb für den Substratträger 3.

Parallel zu einer Tangente an den ringförmigen Substratträger 3 ist eine Transporteinrichtung 12 angeordnet, die als Transportband ausgeführt ist. Auf dieser Transporteinrichtung befinden sich in endloser Reihe zahlreiche Brillengläser 13, die auf Transportpaletten 14 angeordnet sind. Die Transportpaletten 14 haben vorzugsweise Durchbrechungen, deren Durchmesser dem Durchmesser der Brillengläser 13 entspricht. Auf diese Weise können die Brillengläser 13 gleichzeitig von beiden Seiten beschichtet werden, wenn sich auf der Unterseite der Vakuumkammer 2 weitere Beschichtungsquellen befinden und der Substratträger gleichfalls mit entsprechenden Durchbrechungen versehen ist.

Zwischen der Transporteinrichtung 12 und der Vakuumkammer 2 befindet sich ein Schleusensystem 15 mit einer Aufnahmeeinrichtung 16 und einer Ablegeeinrichtung 17, die beide nur symbolisch durch gestrichelte Pfeile angedeutet sind. Mittels der Aufnahmeeinrichtung 16 wird jeweils eine Transportpalette 14 von der Transporteinrichtung 12 abgehoben, durch das Schleusensystem 15 in die Vakuumkammer 2 eingeführt. Nach dem Beschichten durch eine oder mehrere der Beschichtungsstationen 5, 6 und 7 treten die Brillengläser wieder in das Schleusensystem 15 ein und werden durch die Ablegeeinrichtung 17 wieder auf der Transporteinrichtung abgelegt. Es werden also laufend Transportpaletten 14 aufgenommen und abgelegt, so daß sich auf der Transporteinrichtung 12 gewissermaßen eine kontinuierliche Reihe von Brillengläsern 13 befindet. Eine solche Transportpalette 14 mit einem Brillenglas 13 und der bereits beschriebenen Codierung 18 ist in Figur 2 dargestellt.

Die Transporteinrichtung 12 kann auch aus zwei Transportbändern bestehen, die sich mit gleicher Transportrichtung, nämlich tangential zum Substratträger 3, im Bereich des Schleusensystems 15 aneinander anschließen, was jedoch in Figur 1 nicht besonders dargestellt ist. Die Ablage der beschichteten Brillengläser erfolgt dann auf dem zweiten Transportband.

Auf dem durch die Transporteinrichtung 12 vorgegebenen Transportweg der Brillengläser 13 befindet sich vor der Vakuumkammer 1 eine Code-Leseeinrichtung 19, durch die die Codierung 18 abgefragt wird. Das Ausgangssignal der Code-Leseeinrichtung 19 wird über eine Leitung 20 einem Zentralprozessor 21 zugeführt, der über eine Eingabetastatur 22 programmierbar ist. Sollwerte und Meßwerte können abgerufen und auf einer Anzeigeeinheit 23 abgelesen werden. Der Zentralprozessor 21 ist Teil einer Steuereinrichtung 24, zu der drei einzeln einstellbare Stromversorgungen 25, 26 und 27 für die Beschichtungsstationen 5, 6 und 7 gehören. Die Steuerung derartiger Beschichtungsstationen ist jedoch Stand der Technik, so daß sich ein weiteres Eingehen hierauf erübrigt. Über den Zentralprozessor 21 und die Leitung 11 wird auch der nicht gezeigte Antrieb des Substratträgers 3 gesteuert, d.h. die Taktfrequenz und die Drehrichtung des Substratträgers 3. Sofern Gaszuflüsse zu den einzelnen Beschichtungsstationen gesteuert oder geregelt werden müssen, geschieht auch dies durch den Zentralprozessor 21 und nicht gezeigte Gasleitungen und Regelventilen.

Wie sich insbesondere aus der Figur 1 ergibt, wird auch der Beschichtungsprozeß nach dem "just-in-time"-Prinzip betrieben, d.h. im Takt der Fertigungs- und Weiterverarbeitungsanlagen für die Brillengläser. Zu diesen Fertigungsanlagen gehören beispielsweise Stationen zum Schleifen und Polieren der noch zu beschichtenden Brillengläser. Durch die Vermeidung einer manuellen Beschickung herkömmlicher kalottenförmiger Substrathalter unterbleibt auch eine etwaige Verschmutzung oder Verkratzung der Brillengläser.

## Patentansprüche

1. Verfahren zum Beschichten von Brillengläsern (13) in einer Vakuumanlage, **dadurch gekennzeichnet, daß** man
a) die Brillengläser (13) einzeln oder paarweise auf einer Transporteinrichtung (12) kontinuierlich oder quasi-kontinuierlich an eine mit einem rotierenden Substratträger (3) ausgerüstete Vakuum-Durchlaufanlage (1) parallel zu einer Tangente an den Substratträger (3) heranführt, die Brillengläser (13) über ein Schleusensystem (15) in die Vakuum-Durchlaufanlage (1) einführt, sie darin in mindestens einer steuerbaren Beschichtungsstation (5, 6, 7) mit mindestens einer transparenten Schicht beschichtet und anschließend über das Schleusensystem (15) einzeln oder paarweise an eine Transporteinrichtung (12) übergibt, und daß man
b) den Brillengläsern (13) einzeln oder paarweise eine Codierung (18) zuordnet, die Codierung mittels einer Code-Leseeinrichtung (19) abfragt und die Beschichtungsparameter der jeweiligen Beschichtungsstation (5, 6, 7) und den Antrieb des Substratträgers (3) mittels der Code-Leseeinrichtung (19) steuert

2. Verfahren nach Anspruch 1, **dadurch gekennzeichnet, daß** man den Substratträger (3) bei der Herstellung von Mehrfach-Schichten zumindest zeitweise mit entgegengesetztem Drehsinn ansteuert, derart, daß mindestens eine der Beschichtungsstationen (5, 6, 7) mehrfach durchlaufen wird.

3. Verfahren nach Anspruch 1. **dadurch gekennzeichnet, daß** man mindestens eine der Beschichtungsstationen (5, 6, 7) nach dem Prinzip der Katodenzerstäubung betreibt

4. Verfahren nach Anspruch 1, **dadurch gekennzeichnet, daß** man mindestens eine der Beschichtungsstationen (5, 6, 7) nach dem Prinzip der PCVD-Beschichtung betreibt

5. Verfahren nach Anspruch 1, **dadurch gekennzeichnet, daß** man die Brillengläser (13) einzeln oder paarweise auf einer Transportpalette (14) ablegt und die Transportpalette mit der Codierung (18) versieht.

6. Vakuumanlage zum Beschichten von Brillengläsern (13) mit einer Vakuumkammer (2) mit mindestens einer steuerbaren Beschichtungsstation (5, 6, 7) **gekennzeichnet durch**
a) eine Transporteinrichtung (12) für die kontinuierliche oder quasi-kontinuierliche Zufuhr einzeln oder paarweise angeordneter Brillengläser (13) zu der mit einem drehbaren Substratträger (3) ausgerüsteten Vakuumkammer (2),
b) ein Schleusensystem (15), mittels welchem die Brillengläser (13) einzeln oder paarweise in die Vakuumkammer (2) einführbar und nach der Beschichtung zu einer Transporteinrichtung (12) zurückführbar sind, wobei die Bewegungsrichtung der Transporteinrichtung (12) parallel zu einer Tangente an den Substratträger verläuft, und **durch**
c) eine auf dem Transportweg der Brillengläser (13) angeordnete Code-Leseeinrichtung (19) für die Abfrage einer den Brillengläsern (13) einzeln oder paarweise zugeordneten Codierung (18), wobei die Ausgangssignale der Code-Leseeinrichtung einer Steuereinrichtung (24) für die Beschichtungsparameter der mindestens einen Beschichtungsstation (5, 6, 7) und für den Antrieb des Substratträgers (3) aufgeschaltet sind.

7. Vorrichtung nach Anspruch 6, **dadurch gekennzeichnet, daß** die Steuereinrichtung (24) für den Substratträger (3) in der Weise ausgelegt ist, daß der Substratträger zumindest zeitweise mit entgegengesetztem Drehsinn antreibbar ist, derart, daß mindestens eine der Beschichtungsstationen (5, 6, 7) mehrfach durchlaufen wird.

8. Vorrichtung nach Anspruch 6, **dadurch gekennzeichnet, daß** mindestens eine der Beschichtungsstationen (5, 6, 7) als Katodenzerstäubungsvorrichtung ausgebildet ist

9. Vorrichtung nach Anspruch 6, dadurch kennzeichnet, daß mindestens eine der Beschichtungsstationen (5, 6, 7) als PCVD-Beschichtungsquelle ausgebildet ist.

10. Vorrichtung nach Anspruch 6, **gekennzeichnet durch** mit einer Codierung (18) versehene Transportpaletten (14) für den Transport der Brillengläser (13) einzeln oder paarweise auf der Transporteinrichtung (12) und **durch** die Vakuumkammer (2).

## Claims

1. Process for coating spectacle lenses (13) in a vacuum unit, **characterised in that**
a) spectacle lenses (13) are delivered continuously or quasi-continuously, individually or in pairs on a transport mechanism (12) to a straight-through vacuum unit (1), which is equipped with a rotary substrate carrier (3), parallel to a tangent on substrate carrier (3), and the spectacle lenses (13) are guided via a channel system (15) into the straight-through vacuum unit (1), where they are in at least one controllable coating station (5, 6, 7) coated with at least one transparent coating and thereafter passed on individually or in pairs via the channel system (15) to a transport mechanism (12); and
b) the spectacle lenses (13) are individually or in pairs associated with a code (18), a code is read by means of a code-reading device (19), and the coating parameters of the respective coating station (5, 6, 7) and the drive of the substrate carrier (3) are controlled by means of the code-reading device.

2. Process according to Claim 1, **characterised in that** the substrate carrier (3) is in the course of producing multiple coatings at least at times controlled in reverse rotary direction so that at least one of the coating stations (5, 6, 7) is passed through several times.

3. Process according to Claim 1, **characterised in that** at least one of the coating stations (5, 6, 7) is operated on the principle of cathode atomisation.

4. Process according to Claim 1, **characterised in that** at least one of the coating stations (5, 6, 7) is operated on the principle of PCVD coating.

5. Process according to Claim 1, **characterised in that** the spectacle lenses (13) are deposited individually or in pairs on a transport pallet (14), and the transport pallet is provided with a code (18).

6. Vacuum unit for coating of spectacle lenses (13), comprising a vacuum chamber (2) with at least one controllable coating station (5, 6, 7), **characterised by**
a) a transport mechanism (12) for continuous or quasi-continuous delivery of spectacle lenses (13), arranged individually or in pairs, to the vacuum chamber (2) which is equipped with a rotary substrate carrier (3);
b) a channel system (15) by means of which the spectacle lenses (13) are individually or in pairs introduced into the vacuum chamber (2) and, after having been coated, returned to a transport mechanism (12), and the movement direction of the transport device (12) extends parallel to a tangent on the substrate carrier; and
c) a code-reading device (19), arranged on the transport path of the spectacle lenses (13), for reading a code (18) associated individually or in pairs with the spectacle lenses (13), and the output signals of the code-reading device are added onto a control device (24) for coating parameters of the at least one coating station (5, 6, 7) and for the drive of the substrate carrier (3).

7. Device according to Claim 6, **characterised in that** the control device (24) for the substrate carrier (3) is designed in such a manner that the substrate carrier is driven at least at times in reverse direction, so that at least one of the coating stations (5, 6, 7) is passed through repeatedly.

8. Device according to Claim 6, **characterised in that** at least one of the coating stations (5, 6, 7) is designed as a cathode atomisation device.

9. Device according to Claim 6, **characterised in that** at least one of the coating stations (5, 6, 7) is designed as a PVC coating source.

10. Device according to Claim 6, **characterised by** transport pallets (14) provided with a code (18) for transporting the spectacle lenses (13) individually or in pairs on a transport device (12) and through the vacuum chamber (2).

## Revendications

1. Procédé pour revêtir des verres de lunettes (13) dans une installation sous vide, **caractérisé en ce que** :
a) on amène les verres de lunettes (13) individuellement ou par paire sur un dispositif de transport (12) en continu ou de manière quasi-continue jusqu'à une installation sous vide en continu (1) équipée d'un support de substrat (3) en rotation et parallèlement à une tangente du porte-substrat (3), on introduit les verres de lunettes (13) via un système à sas (15) dans l'installation sous vide en continu (1), on les y revêt d'au moins une couche transparente dans au moins une station de revêtement à commande (5, 6, 7) et on les passe ensuite via le système à sas (15) individuellement ou par paire à un dispositif de transport (12), et **en ce que**
b) on associe un codage (18) aux verres de lunettes (13) individuellement ou par paire, on interroge le codage au moyen d'un dispositif de lecture de code (19), et on commande les paramètres de revêtement de la station de revêtement respective (5, 6, 7) et l'entraînement du support de substrat (3) au moyen du dispositif de lecture de code (19).

2. Procédé selon la revendication 1, **caractérisé en ce que** lors de la fabrication de couches multiples, on pilote le support de substrat (3) au moins temporairement dans le sens de rotation opposé, de telle sorte que l'une au moins des stations de revêtement (5, 6, 7) est traversée plusieurs fois.

3. Procédé selon la revendication 1, **caractérisé en ce que** l'une au moins des stations de revêtement (5, 6, 7) fonctionne selon le principe de la pulvérisation cathodique.

4. Procédé selon la revendication 1, **caractérisé en ce que** l'une au moins des stations de revêtement (5, 6, 7) fonctionne selon le principe du revêtement à PCVD.

5. Procédé selon la revendication 1, **caractérisé en ce que** l'on dépose les verres de lunettes (13) individuellement ou par paire sur une palette de transport (14), et **en ce que** l'on pourvoit la palette de transport du codage (18).

6. Installation sous vide pour revêtir des verres de lunettes (13), comportant une chambre sous vide (2) présentant au moins une station de revêtement à commande (5, 6, 7), **caractérisée par** :
a) un dispositif de transport (12) pour amener en continu ou de manière quasi-continue les verres de lunettes (13) agencées individuellement ou par paire à la chambre sous vide (2) équipée d'un support de substrat en rotation (3) ;
b) un système à sas (15) grâce auquel les verres de lunettes (13) peuvent être introduits individuellement ou par paire dans la chambre sous vide (2) et peuvent être ramenés, après le revêtement, à un dispositif de transport (12), la direction de déplacement du dispositif de transport (12) étant parallèle à une tangente du porte-substrat, et par :
c) un dispositif de lecture de code (19) agencé sur le trajet de transport des verres de lunettes (13), pour l'interrogation d'un codage (18) associé individuellement ou par paire aux verres de lunettes (13), et dans lequel les signaux de sortie du dispositif de lecture de code transmis à un dispositif de commande (24) pour les paramètres de revêtement de ladite station de revêtement (5, 6, 7) et pour l'entraînement du support de substrat (3).

7. Dispositif selon la revendication 6, **caractérisé en ce que** le dispositif de commande (24) pour le support de substrat (3) est conçu de telle sorte que le support de substrat peut être entraîné du moins temporairement dans un sens de rotation opposé, de sorte que l'une au moins des stations de revêtement (5, 6, 7) est traversée plusieurs fois.

8. Dispositif selon la revendication 6, **caractérisé en ce que** l'une au moins des stations de revêtement (5, 6, 7) est réalisée sous forme d'un dispositif de pulvérisation cathodique.

9. Dispositif selon la revendication 6, **caractérisé en ce que** l'une au moins des stations de revêtement (5, 6, 7) est réalisée sous forme d'une source de revêtement à PCVD.

10. Dispositif selon la revendication 6, **caractérisé par** des palettes de transport (14) pourvues d'un codage (18) pour le transport des verres de lunettes (13) individuellement ou par paire sur le dispositif de transport (12) et à travers la chambre sous vide (2).
